Europäisches Patentamt

European Patent Office

Office européen des brevets

(19)

(11) Publication number: **0 214 899 B1**

(12)

# EUROPEAN PATENT SPECIFICATION

(45) Date of publication of patent specification :
**13.03.91 Bulletin 91/11**

(51) Int. Cl.$^5$ : **G05F 1/46**

(21) Application number : **86401816.3**

(22) Date of filing : **14.08.86**

(54) Semiconductor device having means for regulating power supply voltage applied thereto.

(30) Priority : **16.08.85 JP 179444/85**

(43) Date of publication of application :
**18.03.87 Bulletin 87/12**

(45) Publication of the grant of the patent :
**13.03.91 Bulletin 91/11**

(84) Designated Contracting States :
**DE FR GB**

(56) References cited :
**EP-A- 0 015 070**
**EP-A- 0 046 482**
**EP-A- 0 063 483**
**EP-A- 0 121 793**
**US-A- 4 281 261**

(73) Proprietor : **FUJITSU LIMITED**
**1015, Kamikodanaka Nakahara-ku**
**Kawasaki-shi Kanagawa 211 (JP)**

(72) Inventor : **Aoyama, Keizo**
**6-11, Tsukimino 7-chome**
**Yamato-shi Kanagawa 242 (JP)**

(74) Representative : **Descourtieux, Philippe et al**
**CABINET BEAU de LOMENIE 55 rue**
**d'Amsterdam**
**F-75008 Paris (FR)**

## Description

The present invention relates to a semiconductor device including an integrated circuit (IC) or a large scale integrated circuit (LSI).

It relates more particularly to a semiconductor device (hereinafter named a semiconductor chip or a chip for the sake of simplicity) having a means for regulating the external power supply voltage applied thereto to compensate chip-to-chip dispersion of electrical characteristics of the chip, such as power supply current to the chip.

As a consequence of the dramatically increasing packing density of ICs, especially metal oxide semiconductor (MOS) ICs, the dimensional structure of the semiconductor chip becomes very fine, as referred to in Electronics, Aug. 18. 1977, page 94-99, by Richard Pashley et al, causing various problems in the production line. This leads to make the requirement for accuracy and preciseness of the relevant production technology of transistors more and more severe.

Taking MOS field effect transistors (FETs) for example, their channel length has been shortened down to 2 μm in a recent production line. With an MOS FET having a polysilicon gate electrode, the channel length is defined by the width of the gate electrode since self-aligned dopant ion implanation method is applied to form source-drain regions of the associated MOS FET, using the gate electrode as a mask. The accuracy of the dimension of gate electrode is adversely affected by its inadequate production process : such as over etching of the photoresist film (mask) for patterning the polysilicon gate electrode, incorrect lithography patterning of the photoresist film due to uneven surface of the substrate, over etching of the polysilicon layer for the formation of the gate electrode, etc.. Such fabrication processes are effected to every semiconductor wafer on which a number of semiconductor chips are built in. The dispersion of the dimensions of the FETs, therefore, is found from wafer to wafer, that is, from chip to chip when many chips are used in an electronic circuit. For example, chip-to-chip dispersion of the channel length of approximately ± 0.2 μm is found in MOS FETs under the present production technology, bringing approximately 10% dispersion of the electric characteristics such as conductance gm, threshold voltage $V_{th}$, and source-drain breakdown voltage. On the contrary, the dispersion between individual FETs contained in one semiconductor chip is fairly small.

Generally, in an electronic circuit, a great number of semiconductor chips, or IC chips are mounted and power is commonly supplied to individual chips from an external power source of the circuit. As a result, problems due to the dispersion of electric characteristics of each FET may occur such as too high power supply current for chips containing FETs having high conductance FETs namely short channel length, and too low power supply current and low switching speed for chips containing FETs having low conductance FETs, namely long channel length and high gate-source capacitance. This results in degradation of the efficiency and stability of the circuit.

The above described chip-to-chip dispersion of electric characteristics of FETs mounted on every chip is inevitable to some degree at present. It is rather difficult and costly to upgrade the accuracy and stability of the fabrication process of the semiconductor chips. Thus, another substituting method has been expected in the art.

It is an object of the present invention to provide a semiconductor chip having a means capable of compensating for a chip-to-chip dispersion of the electrical characteristics of transistors mounted thereon in order to achieve a uniform and reliable operation of the semiconductor chips when they are used in a great number in an electronic circuit.

It is still another object of the present invention to provide a semiconductor chip having a regulating means of the external power supply voltage applied thereto controlled by a representing signal of the electric characteristics of the transistors mounts on each chip.

It is a further object of the present invention to provide semiconductor chips used in an electronic circuit with high reliability by economically compensating the dispersion of the electrical characteristics of every chip caused by the inherent non-uniformity of the associated production process.

These objects are achieved, in a known semiconductor device of the kind described for instance in EP-A-0 121 793 and defined in the preamble of claim 1, by carrying out the features recited in the charaterizing part of this claim.

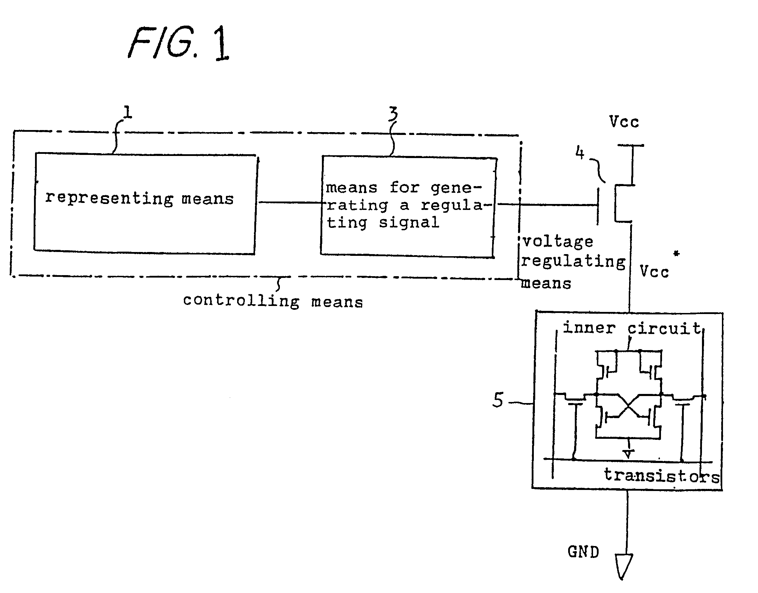

Fig. 1 is a block diagram of power supply voltage regulating circuit formed in a semiconductor chip according to the present invention, illustrating the principle of operation. The circuit comprises a controlling means, including a means 1 for providing a representing signal representing electrical characteristics of the FETs in inner circuit 5 (hereinafter referred to simply as representing means 1), a means 3 for generating a regulating signal according to the representing signal (hereinafter referred to simply as regulating signal generating means 3), and a regulating means 4 of external power supply voltage (hereinafter referred to simply as regulating means 4). Hereby, the external power supply voltage Vcc is applied to an inner circuit 5 such as a memory circuit formed on the semiconductor chip through regulating means 4 which regulates the voltage Vcc. While, representing means 1 detects electric characteristics such as conductance of FETs mounted in inner circuit 5. The representing signal from the representing means 1 is fed to regulating signal generating means 3, and the output signal therefrom is applied to regulating means 4. Thus the voltage Vcc is regulated to an internal power supply voltage Vcc which is applied to inner circuit 5, compensating the chip-to-chip dispersion of electric characteristics of FETs contained therein. As a result, for a semiconductor chip having FETs with rather higher conductance, for example, the external power supply voltage Vcc is regulated to a relatively low internal power supply voltage Vcc* which is applied to inner circuit 5 of the chip, thus avoiding a high power supply current to the chip which otherwise would occur.

Before further proceeding, a brief description will be given about the relation between electric characteristics and channel length of FETs. Conductance, for example, of an FET is inversely proportional to the channel length. For a short channel length such as 2 μm, the conductance is high and varies very sensitively with the channel length. An FET having a short channel length, therefore, is very difficult to fabricate with well controlled electrical characteristics. On the other hand, the FET is suitable to monitor the dispersion of electric characteristics of FETs contained in the inner circuit 5 rich is caused under fluctuated production condition. Thus, an FET with short channel length is used as a sensitive dummy FET for representing means 1. On the other hand, in an FET having a relatively long channel length such as longer than 5 μm, the conductance is low and dull to the variation of the channel length. Such FETs are suitably used for the controlling means 1 except above described dummy FET because their electric characteristics are less affected by the channel length and can maintain a relatively stable function even under some dispersed production condition. Furthermore, it can be said that the dispersion of the power supply current, for example, to each semiconductor chip contained in an electronic circuit, right be mainly attributed to the FETs having high conductance, namely, short channel length.

In the following, through all this specification, terms of "short" or "long" used for the relevant channel length, have the meaning as described above.

For representing the electric characteristics of FETs used in inner circuit 5, the voltage drop across the dummy FET is utilized as a representing signal indicating the electric characteristics of the FETs contained in the inner circuit, because the dummy FET and the FETs of inner circuit 5 are fabricated on the same wafer and under the same fabricating condition, and the dummy FET and some of the FETs of the inner circuit 5 have short channel length similar to each other.

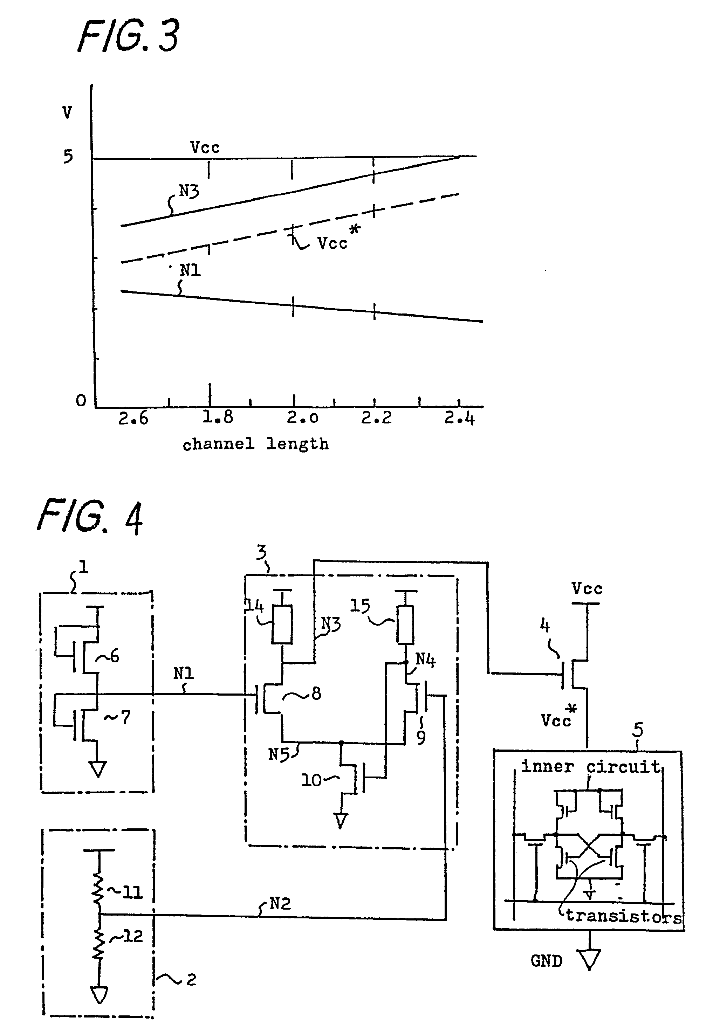

Regulating signal generating means 3 is basically a simple amplifier. Furthermore, in order to avoid the deviation of external power supply voltage Vcc from the predetermined value, an improved controlling means is disclosed. For this purpose, a reference voltage generating means, as shown in Fig. 4, is introduced and a reference voltage signal therefrom is applied to a differential amplifier to feed back the deviation of the external power supply voltage.

Regulating means 4 itself is an FET, conductance of which is regulated by the regulating signal applied to its gate electrode. The external power supply voltage Vcc is applied to the regulating means 4, namely FET 4, through an external power supply line. According to the regulated conductance of the FET, the voltage drop across the FET is varied, newly providing an internal power supply voltage Vcc* which is applied to inner circuit 5. Thus, external power supply voltage Vcc is regulated to an internal power supply voltage Vcc* corresponding to the conductance of the FET of the semiconductor chip. In other words, the compensation of the fluctuation of production conditions in the line can be achieved. As such, the inherent difficulty of the production control of semiconductor devices such as IC or LSI is overcome relatively easily and economically.

These objects and advantages, which will be subsequently apparent, reside in the details of circuit configuration, as hereinafter described and claimed with more details, reference being made to the accompanying drawings forming a part hereof, wherein like numerals refer to like parts throughout.

Fig. 1 is a block diagram of a power supply regulating circuit formed on a semiconductor device according to the present invention, illustrating the principle of the operation of the circuit.

Fig. 2 is a wiring diagram of a circuit of a first preferred embodiment according to the present invention.

Fig. 3 is a diagram illustrating the relation between channel length of a dummy FET and potential of every node shown in Fig. 1.

Fig. 4 is a wiring diagram of an improved circuit of a second preferred embodiment.

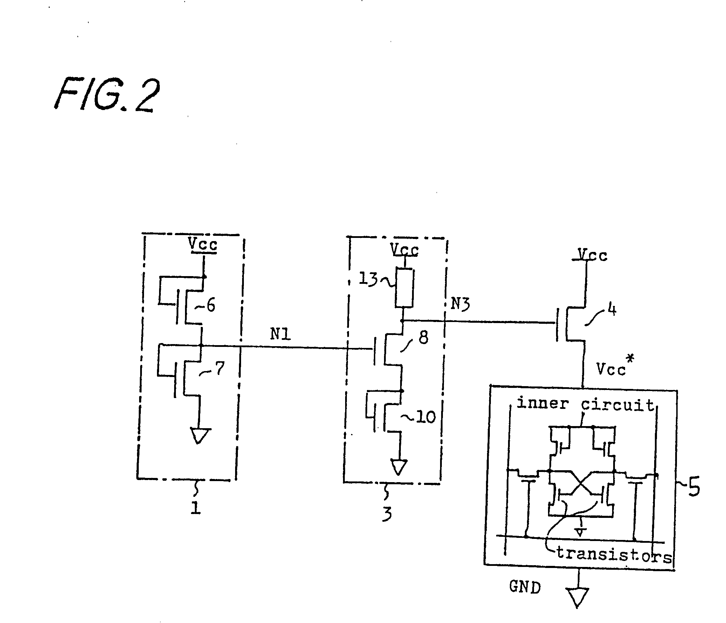

Fig. 2 is a circuit diagram of a first preferred embodiment of the present invention comprising a controlling means including a representing means 1 and a regulating signal generating means 3, a voltage regulating means 4 (FET 4), and an inner circuit 5, all of which is formed on a chip. Through all the description of the embodiments, all the FETs used are assumed to be N-type channel FETs unless otherwise mentioned. In Fig. 2, the FETs 4, 7, 8, and 10 have relatively long channel length. Thus, their electric characteristics are fairly insensitive to the dispersion of their channel length, namely to the fluctuation of the associated production condition under which the FETs or relevant chips are made. On the other hand, FET 6 is a dummy FET, having a short channel length. Its electric characteristics respond sensitively to the variation of the channel length, making this FET suitable for monitoring the variation of electric characteristics of the FETs on the chip caused by the fluctuation of the production condition as described before.

Representing means 1 is composed of dummy FET 6 and diode connected FET 7, which constitutes a load transistor. Both FETs are connected in series at node N1. From an external power source (not shown), external power supply voltage Vcc is applied to the drain of FET 6 through an external power supply line (not shown) and the source of FET 7 is connected to another power supply line (not shown), usually, a ground line. The next stage is a regulating signal generator 3, including load resistor 13 connected to the external power source of voltage Vcc, amplifying transistor FET 8 whose drain is connected to load resistor 13 at node N3, and diode connected load transistor FET 10. Load resistor 13, FET 8 and FET 10 are connected to each other in series in the recited order. The potential of node N1, $V_{N1}$, is fed to the gate electrode of FET 8. The potential of node N3, $V_{N3}$, at which load resistor 13 and the drain of FET 8 are connected to each other is applied to the gate electrode of FET 4, a regulating means, controlling the conductance of FET 4 whose drain and source are connected to the external power supply line and inner circuit 5 respectively.

Fig. 3 shows the relation between the channel length of dummy FET 6 and potentials at various nodes shown in Fig. 2. The abscissa is taken as the channel length axis, and the node potentials are plotted on the ordinate as a function of the channel length. As described before, the channel length is controlled in the production line, for example, within ± 0.2 μm according to the present production technology. Assuming that the channel length is designed to be 2 μm, the channel length will be controlled within the range from 2.2 μm, to 1.8 μm. The whole regulating circuit including representing means 1, regulating signal generating means 3 and regulating means 4 is usually designed such that the voltage drop across FET 4 comes to minimum when the channel length of FET 6 is maximum, hereby 2.2 μm. When the channel length becomes shorter, the conductance gm of FET 6 becomes higher, and resulted smaller voltage drop of FET 6 provides a higher potential $V_{N1}$ which reduces the voltage drop across FET 8, resulting in a lowered potential $V_{N3}$. Since the gate potential of FET 4, namely potential $V_{N3}$, comes down, the voltage drop across FET 4 increases, providing a descended internal power supply voltage Vcc*. Now the relatively low Vcc* is applied to inner circuit 5 which has a relatively high total conductance. As the result, a higher power supply current to the chip which otherwise might occur is favourably avoided.

The first embodiment is a simple circuit which puts into practice the principle of the present invention, but may have some unstable operation. For example, if the level of external power supply voltage Vcc shown in Fig. 2 becomes significantly higher than the specified voltage, the potential voltages of $V_{N1}$ and $V_{N3}$ go up, providing a rather higher Vcc* than the originally aimed one.

An improved second emdodiment aiming at achieving a more stable operation wherein the influence of the deviation of the external power supply voltage Vcc is reduced as much as possible, will now be described. The ultimate purpose of the circuit of the second embodiment is to maintain the potential of the gate electrode of FET 4, namely node potential $V_{N3}$, immune from the deviation of the external power supply voltage Vcc from the predetermined value.

Fig. 4 shows the circuit diagram of the second embodiment. The second embodiment, like the first embodiment, comprises a controlling means and a regulating means 4. The controlling means includes a representing means 1, a reference voltage generating means 2 and a more complicated regulating signal generating means 3. Reference voltage generator 2 is composed of two resistors 11, 12 connected in series at node N2. Resistor 11 is connected to an external power supply line, and resistor 12 is connected to the ground line. Thus the voltage Vcc is divided in proportion to the ratio of resistances of both resistors 11, 12, and a reference voltage of a value $V_{N2}$ is obtained.

Regulating signal generator 2 is a differential amplifier which is a well known circuit disclosed in U.S. Patent No. 4,375,039, published Feb. 22, 1983, issued to Yamauchi, and is composed of three transistors FET 8, 9, 10 and two load resistors 14, 15. The drains of the transistors FET 8 and 9 are connected to load resistors 14, 15 respectively at respective nodes N3 and N4, and the sources of both transistors are commonly connected to the common transistor, FET 10, at node N5. The source of FET 10 is grounded. The external power supply voltage Vcc is applied to both load resistors 14, 15 at their other terminals. The differential amplifier has two input terminals, a first and a second input terminal at nodes N1 and N2, connected to each gate electrode of FETs 8, 9, and one output terminal at node N3 connected to regulating transistor FET 4. The other output terminal, node N4 is fed back to the gate electrode of the common transistor FET 10 in such a manner that the reference voltage, i.e. the voltage of node N5, $V_{N5}$ is variable.

The operation of the regulating signal generator 3, namely the differential amplifier of Fig. 4, will now be described. A representing signal voltage $V_{N1}$ of electric characteristics of the associated FETs is obtained from representing means 1, in the same manner as that of the first embodiment shown in Fig. 2, and is fed to a first input terminal of the differential amplifier, namely the gate electrode of FET 8. Voltage $V_{N2}$ is fed from reference voltage generating means 2 to the second input terminal, namely the gate electrode of FET 9. Since the operation caused by the variation of dummy FET 6 is the same as that of the first embodiment, it will not be further discussed hereby. Only the affection of the variation of Vcc will be discussed under the assumption that the conductance of dummy FET 6 is fixed, and only Vcc increases.

When Vcc goes up to some degree, the node potentials $V_{N1}$, $V_{N2}$, $V_{N3}$ and $V_{N4}$ naturally tend to go up. For the sake of clarity, these increases in node potentials which are directly caused by the rise of Vcc, are referred to as original increases. Now the results of the rise of Vcc will be followed referring to Fig. 4.

The original rise of $V_{N2}$ increases the conductance of FET 9, which results in a depression of the node voltage $V_{N4}$. Taking into account the original rise of $V_{N4}$, the node voltage $V_{N4}$ slightly goes up in total, increasing the conductance of FET 10, which results in a depression of node potential $V_{N5}$. Combined with the original rise of $V_{N1}$, the decrease in $V_{N5}$ increases the conductance of FET 8, acting to depress the node potential $V_{N3}$. Thus, the effect of the original rise of $V_{N3}$ is, even though not perfectly emilinated, at least partially compensated. It can be said that the differential amplifier operates in such a manner that the effect of the rise of external supply voltage Vcc is reduced to some degree to realize a more reliable operation. Of course, when the voltage Vcc is decreased from the specified voltage, the operation of the circuit proceeds in the reversed direction, and further description thereof might be unnecessary for the skilled people in the art.

The present invention may be embodied in other specific form without departing from the spirit or essential characteristics thereof. The presently disclosed embodiments are, therefore, to be considered in all respects as illustrative and not restrictive, the scope of the invention being indicated by the appended claims, rather than the foregoing description, and all changes which come within the meaning and range of equivalency of the claims are therefore to be embraced therein.

## Claims

1. A semiconductor device receiving external power supply voltage, comprising :
   a semiconductor substrate ;
   an inner circuit (5) formed on said semiconductor substrate and containing a plurality of transistors;
   a voltage regulating means (4) formed on said substrate for regulating said external power supply voltage (Vcc) in accordance with a regulating signal and converting said external power supply voltage (Vcc) to an internal power supply voltage (Vcc*) to be applied to said inner circuit (5) ; and
   a controlling means (1, 3 ; 1, 2, 3) formed on said semiconductor substrate for controlling said regulating means (4) in dependence on the electric characteristics of said transistors, so that fluctuation in the electric characteristics of said transistors is compensated,
   said controlling means (1, 3) comprising :
   a means (1) for providing a representing signal which represents the electric characteristics of said transistors, comprising a dummy transistor (6) and a load transistor (7) connected in series, said dummy transistor (6) being connected to an external power supply line and said load transistor (7) being connected to a further power supply line, and a voltage ($V_{N1}$) of the node ($N_1$) between said dummy and load transistors (6, 7) being fed to the subsequent stage (3) as said representing signal, and
   a means (3) for generating a regulating signal in dependence on said representing signal, comprising transistors (8, 10 ; 8, 9, 10),
   characterized in that said transistors (7, 8, 10 ; 7, 8, 9, 10) used in said controlling means (1, 3), except said dummy transistor (6), are FETs having long channel length which is sufficient to make the electric characteristics of said FETs substantially non-sensitive to variation of the channel length of said FETs, and in that said dummy transistor (6) is a FET having a short channel length sufficient to make the electric characteristics of said FET sensitive to variation of the channel length of said FET.

2. The semiconductor device according to claim 1 wherein said means (3) for generating a regulating signal comprises :
   a first load means (13) connected to an external power supply line ;
   an amplifying transistor (8) connected to said first load means (13) in series ; and
   a second load means (10) formed by a transistor connected to said amplifying transistor (8) and to a power supply line in series,
   said representing signal being inputted to the gate electrode of said amplifying transistor (8) and a voltage ($V_{N3}$) of a node ($N_3$) between said first load means (13) and said amplifying transistor (8) being fed to the subsequent stage (4) as said regulating signal.

3. The semiconductor device according to claim 1, characterized in that said controlling means (1, 2, 3) further comprises :
   a means (2) for generating a reference voltage ($V_{N2}$) depending on said external power supply voltage (Vcc) ; and in that
   said means (3) for generating a regulating signal is adapted to generate a regulating signal according to said representing signal ($V_{N1}$) and said reference voltage ($V_{N2}$),
   so that the fluctuation of electric characteristics of said transistors is compensated, depending on said external power supply voltage.

4. The semiconductor device according to claim 3, characterized in that said means (2) for generating reference voltage comprises :

first and second resistors (11, 12) connected in series to each other, said first resistor (11) being connected to said external power supply line, and said second resistor (12) being connected to a power supply line, and the voltage of the node between said first resistor (11) and second resistor (12) being fed to the subsequent stage (3) as a reference voltage signal ($V_{N2}$).

5. The semiconductor device according to claim 3 or 4 characterized in that said means (3) for generating a regulating signal comprises :

first and second load means (14, 15) connected to an external power supply line ;

first and second input transistors (8, 9) connected in series to said first and second load means (14, 15) respectively ; and

a common transistor (10) commonly connected to said first and second transistors (14, 15), and connected to a power supply line, said representing signal ($V_{N1}$) and said reference signal voltage ($V_{N2}$) being applied to the gate electrodes of said first and second input transistors (8, 9) respectively, the voltage ($V_{N4}$) of a node between said second load means (15) and said second input transistor (9) being fed back to the gate electrode of said common transistor (10), and the voltage ($V_{N3}$) of a node between said first load means (14) and said first input transistor (8) being fed to the subsequent stage as said regulating signal.

6. The semiconductor device according to any one of claims 1 to 5, characterized in that said transistors are metal insulator semiconductor (MIS) field effect transistors (FET).

7. The semiconductor device according to any one of claims 1 to 6, characterized in that said electric characteristics of said transistors is conductance.

**Revendications**

1. Un dispositif semiconducteur recevant une tension d'alimentation électrique externe, comprenant :

un substrat semiconducteur ;

un circuit interne (5) formé sur ledit substrat semiconducteur et contenant plusieurs transistors ; un moyen de régulation de tension (4) formé sur ledit substrat afin de réguler ladite tension d'alimentation électrique externe (Vcc) en fonction d'un signal de régulation et de convertir ladite tension d'alimentation électrique externe (Vcc) en une tension d'alimentation électrique interne (Vcc*) à appliquer audit circuit interne (5) ; et

un moyen de commande (1, 3 ; 1, 2, 3) formé sur ledit substrat semiconducteur afin de commander ledit moyen de régulation (4) en fonction des caractéristiques électriques desdits transistors, de sorte que les fluctuations des caractéristiques électriques desdits transistors soient compensées,

ledit moyen de commande (1, 3) comprenant :

un moyen (1) servant à produire un signal représentatif qui représente les caractéristiques électriques desdits transistors, comprenant un transistor fictif (6) et un transistor de charge (7) connectés en série, ledit transistor fictif (6) étant connecté à une ligne d'alimentation électrique externe et ledit transistor de charge (7) étant connecté à une autre ligne d'alimentation électrique, la tension ($V_{N1}$) du noeud ($N_1$) existant entre ledit transistor fictif (6) et ledit transistor de charge (7) étant fournie à l'étage suivant (3) au titre dudit signal représentatif, et

un moyen (3) servant à produire un signal de régulation en fonction dudit signal représentatif, comprenant des transistors (8, 10 ; 8, 9, 10), caractérisé en ce que lesdits transistors (7, 8, 10 ; 7, 8, 9, 10) utilisés dans ledit moyen de commande (1, 3), à l'exception dudit transistor fictif (6), sont des transistors à effet de champ, ou FET, possédant une grande longueur de canal qui est suffisante pour rendre les caractéristiques électriques desdits FET pratiquement insensibles aux variations de la longueur de canal desdits FET, et en ce que ledit transistor fictif (6) est un FET possédant une courte longueur de canal qui est suffisante pour rendre les caractéristiques électriques dudit FET sensibles aux variations de la longueur de canal dudit FET.

2. Dispositif semiconducteur selon la revendication 1, où ledit moyen (3) servant à produire un signal de régulation comprend :

un premier moyen de charge (13) connecté à une ligne d'alimentation électrique externe ;

un transistor d'amplification (8) connecté en série avec ledit premier moyen de charge (13) ; et

un deuxième moyen de charge (10) formé par un transistor connecté en série avec ledit transistor d'amplification (8) et une ligne d'alimentation électrique,

ledit signal représentatif étant appliqué à l'électrode de grille dudit transistor d'amplification (8) et la tension ($V_{N3}$) du noeud ($N_3$) formé entre ledit premier moyen de charge (13) et ledit transistor d'amplification (8) étant envoyée à l'étage suivant (4) au titre dudit signal de régulation.

3. Dispositif semiconducteur selon la revendication 1, caractérisé en ce que ledit moyen de commande (1, 2, 3) comprend en outre :

un moyen (2) servant à produire une tension de référence ($V_{N2}$) en fonction de ladite tension d'alimentation électrique externe (Vcc), et en ce que ledit moyen (3) servant à produire un signal de régulation est conçu pour produire un signal de régulation en fonction dudit signal représentatif

($V_{N1}$) et de ladite tension de référence ($V_{N2}$),

de sorte que les fluctuations des caractéristiques électriques desdits transistors sont compensées, en fonction de ladite tension d'alimentation électrique externe.

4. Dispositif semiconducteur selon la revendication 3, caractérisé en ce que ledit moyen (2) servant à produire une tension de référence comprend :

des première et deuxième résistances (11, 12) connectées en série entre elles, ladite première résistance (11) étant connectée à ladite ligne d'alimentation électrique externe, et ladite deuxième résistance (12) étant connectée à une ligne d'alimentation électrique, la tension du noeud existant entre ladite première résistance (11) et ladite deuxième résistance (12) étant appliquée à l'étage suivant (3) au titre de signal de tension de référence ($V_{N2}$).

5. Dispositif semiconducteur selon la revendication 3 ou 4, caractérisé en ce que ledit moyen (3) servant à produire un signal de régulation comprend :

des premier et deuxième moyens de charge (14, 15) connectés à une ligne d'alimentation électrique externe ;

des premier et deuxième transistors d'entrée (8, 9) connectés respectivement en série avec lesdits premier et deuxième moyens de charge (14, 15) ; et

un transistor commun (10) connecté en commun auxdits premier et deuxième transistors (14, 15) et connecté à une ligne d'alimentation électrique, ledit signal représentatif ($V_{N1}$) et ledit signal de tension de référence ($V_{N2}$) étant respectivement appliqués aux électrodes de grille desdits premier et deuxième transistors d'entrée (8, 9), la tension ($V_{N4}$) du noeud présent entre ledit deuxième moyen de charge (15) et ledit deuxième transistor d'entrée (9) étant renvoyée, en réaction, sur l'électrode de grille dudit transistor commun (10), et la tension ($V_{N3}$) du noeud présent entre ledit premier moyen de charge (14) et ledit premier transistor d'entrée (8) étant envoyée à l'étage suivant au titre dudit signal de régulation.

6. Dispositif semiconducteur selon l'une quelconque des revendications 1 à 5, caractérisé en ce que lesdits transistors sont des transistors à effet de champ (FET) du type métal-isolant-semiconducteur (MIS).

7. Dispositif semiconducteur selon l'une quelconque des revendications 1 à 6, caractérisé en ce que lesdites caractéristiques électriques desdits transistors sont la conductance.

## Ansprüche

1. Halbleitervorrichtung, die eine externe Energieversorgungsspannung empfängt, mit :

einem Halbleitersubstrat ;

einer inneren Schaltung (5), die auf dem genannten Substrat gebildet ist und eine Vielzahl von Transistoren enthält ;

einer Spannungsregeleinrichtung (4), die auf dem genannten Substrat gebildet ist, um die genannte externe Energieversorgungsspannung (Vcc) in übereinstimmung mit einem Regelsignal zu regeln und die genannte externe Energieversorgungsspannung (Vcc) zu einer internen Energieversorgungsspannung (Vcc*) zu wandeln, die der genannten inneren Schaltung (5) zugeführt werden soll ; und

einer Steuereinrichtung (1, 3 ; 1, 2, 3), die auf dem genannten Halbleitersubstrat zum Steuern der genannten Regeleinrichtung (4) in Abhängigkeit von den elektrischen Charakteristiken der genannten Transistoren derart gebildet ist, daß eine Fluktuation der elektrischen Charakteristiken der genannten Transistoren kompensiert wird,

welche Steuereinrichtung (1, 3) umfaßt

eine Einrichtung (1) zum Liefern eines repräsentierenden Signals, welches die elektrischen Charakteristiken der genannten Transistoren repräsentiert, einschließlich eines Blindtransistors (6) und eines Lasttransistors (7), die in Reihe miteinander verbunden sind, wobei der genannte Blindtransistor (6) mit einer externen Energieversorgungsleitung verbunden ist und der Lasttransistor (7) mit einer weiteren Energieversorgungsleitung verbunden ist, und eine Spannung ($V_{N1}$) des Knotens ($N_1$) zwischen den genannten Blind- und Lasttransistoren (6, 7) der folgenden Stufe (3) als das genannte repräsentierende Signal zugeführt wird, und

eine Einrichtung (3), zum Erzeugen eines Regelsignals in Abhängigkeit vom dem genannten repräsentierenden Signal, mit Transistoren (8, 10 ; 8, 9, 10),

dadurch gekennzeichnet, daß die genannten Transistoren (7, 8, 10 ; 7, 8, 9, 10), die in der genannten Steuereinrichtung (1, 3) verwendet werden, mit Ausnahme des genannten Blindtransistors (6), FETs sind, die eine lange Kanallänge haben, die ausreicht, um die elektrischen Charakteristiken der genannten FETs gegenüber einer Variation der Kanallänge der genannten FETs im wesentlichen unempfindlich zu machen, und daß der genannte Blindtransistor (6) ein FET ist, der eine kurze Kanallänge hat, die ausreicht, um die elektrischen Charakteristiken des genannten FET gegenüber Variationen der Kanallänge des genannten FET empfindlich zu machen.

2. Halbleitervorrichtung nach Anspruch 1, bei der die genannte Einrichtung (3) zum Erzeugen eines Regelsignals umfaßt :

eine erste Lasteinrichtung (13), die mit einer externen Energieversorgungsleitung verbunden ist ;

einen verstärkenden Transistor (8), der mit der genannten Lasteinrichtung (13) in Reihe verbunden ist ; und

eine zweite Lasteinrichtung (10), die durch einen Transistor gebildet ist, der mit dem genannten verstärkenden Transistor (8) und einer Energieversorgungsleitung in Reihe verbunden ist,

wobei das genannte repräsentierende Signal der, Gateelektrode des genannten verstärkenden Transistors eingegeben wird, und eine Spannung ($V_{N3}$) eines Knotens ($N_3$) zwischen der genannten ersten Lasteinrichtung (13) und dem genannten verstärkenden Transistor (8) der folgenden Stufe (4) als ein Regelsignal zugeführt wird.

3. Halbleitervorrichtung nach Anspruch 1, dadurch gekennzeichnet, daß die genannte Steuereinrichtung (1, 2, 3) ferner umfaßt :

eine Einrichtung (2) zum Erzeugen einer Referenzspannung ($V_{N2}$), abhängig von der genannten externen Energieversorgungsspannung (Vcc) ; und daß

die genannte Einrichtung (3) zum Erzeugen eines Regelsignals angepaßt ist, um ein Regelsignal in Übereinstimmung mit dem genannten repräsentierenden Signal ($V_{N1}$) und der genannten Referenzspannung ($V_{N2}$) zu erzeugen, so daß die Fluktuation von elektrischen Charakteristiken der genannten Transistoren kompensiert wird, abhängig von der genannten externen Energieversorgungsspannung.

4. Halbleitervorrichtung nach Anspruch 3, dadurch gekennzeichnet, daß die genannte Einrichtung (2) zum Erzeugen einer Referenzspannung umfaßt :

erste und zweite Widerstände (11, 12), die in Reihe miteinander verbunden sind, wobei der genannte erste Widerstand (11) mit der genannten externen Energieversorgungsleitung verbunden ist und der genannte zweite Widerstand (12) mit einer Energieversorgungsleitung verbunden ist, und die Spannung des Knotens zwischen dem genannten ersten Widerstand (11) und dem zweiten Widerstand (12) der nachfolgenden Stufe (3) als ein Referenzspannungssignal ($V_{N2}$) zugeführt wird.

5. Halbleitervorrichtung nach Anspruch 3 oder 4, dadurch gekennzeichnet, daß die genannte Einrichtung (3) zum Erzeugen eines Regelsignals umfaßt :

erste und zweite Lasteinrichtungen (14, 15), die mit einer externen Energieversorgungsleitung verbunden sind ;

erste und zweite Eingangstransistoren (8, 9), die in Reihe mit den genannten ersten bzw. zweiten Lasteinrichtungen (14, 15) verbunden sind, und einen gemeinsamen Transistor (10), der gemeinsam mit den genannten ersten und zweiten Transistoren (14,15) verbunden ist und mit einer Energieversorgungsleitung verbunden ist,

wobei das genannte repräsentierende Signal ($V_{N1}$) und die genannte Referenzsignalspannung ($V_{N2}$) den genannten Gateelektroden des genannten ersten Transistors bzw. des genannten zweiten Transistors (8, 9) zugeführt wird, die Spannung ($V_{N4}$) eines Knotens zwischen der genannten zweiten Lasteinrichtung (15) und dem genannten zweiten Eingangstransistor (9) zu der Gateelektrode des genannten Transistors (10) rückgeführt wird, und die Spannung ($V_{N3}$) eines Knotens zwischen der genannten ersten Lasteinrichtung (14) und dem genannten ersten Eingangstransistor (8) der nachfolgenden Stufe als das genannte Regelsignal zugeführt wird.

6. Halbleitervorrichtung nach einem der Ansprüche 1 bis 5, dadurch gekennzeichnet, daß die genannten Transistoren Metall-Isolator-Halbleiter-(MIS)-Feldeffekttransistoren (FET) sind.

7. Halbleitervorrichtung nach einem der Ansprüche 1 bis 6, dadurch gekennzeichnet, daß die genannten elektrischen Charakteristiken der genannten Transistoren die Konduktanz sind.

EP 0 214 899 B1

# FIG. 1

representing means

means for gene-
rating a regula-
ting signal

voltage
regulating
means

controlling means

Vcc

Vcc

inner circuit

transistors

GND

FIG.2

# FIG. 3

# FIG. 4